# EUROPEAN PATENT APPLICATION

(11) **EP 3 988 686 A1**
(43) Date of publication of application: **27.04.2022**
(21) Application number: 21204575.1
(22) Date of filing: 25.10.2021
(51) Int. Cl.: C23C 16/513, C23C 16/455, C23C 16/505, B01J 37/02, B05D 1/00

(54) **PROCESS FOR MANUFACTURING A CATALYTIC COATING AND DEVICE FOR HETEROGENEOUS CATALYSIS**

(30) Priority: 26.10.2020 IT 202000025261
(71) Applicant: Nadir S.r.l., 35134 Padova (IT)
(72) Inventor: SCATTO, MARCO, 30035 Mirano (VE) (IT); VERGA FALZACAPPA, EMANUELE, 31020 Villorba (TV) (IT); SCOPECE, PAOLO, 30038 Spinea (VE) (IT)
(74) Representative: Caldon, Giuliano

(57) **Abstract**

Process for making a catalytic coating (1), which comprises a step of arranging a plasma generation device (2), comprising an ionization duct (3) and an electromagnetic field generator (4); a substrate (10), which is placed at an outlet section (32) of the plasma generation device (2); and a precursor of a non-metallic organic catalyst.

The process also provides for a feeding step, in which the precursor is introduced into the ionization duct (3), and an ionization step, in which the electromagnetic field generator (4) generates an electromagnetic field which interacts with the precursor, ionizing it and producing ionized fragments (5) of the precursor.

The process also comprises a coating step, in which the ionized fragments (5) of the precursor exit outward from the ionization duct (3) and are applied to the substrate (10), and in which the ionized fragments react with each other, forming a plasma-polymer with catalytic functions, forming a catalytic coating (1).

## Description

The project that led to the present invention received financing from Bio-Based Industries Joint Undertaking according to the European Union Horizon 2020 Program for Research and Innovation under subsidy regulation No. 745766.

### Field of application

The present invention regards a process for making a catalytic coating and a catalyst device for heterogeneous catalysis according to the preamble of the respective independent claims.

The present process and catalyst device are generally inserted in the industrial field of production of catalysts for the chemical industry.

More in detail, the catalyst device is inserted in the field of synthesis of organic molecules, in particular polymers, in the chemical industry.

The process is thus advantageously intended to be used for making catalytic coatings on different types of supports, obtaining heterogeneous catalyst devices of different shapes and sizes, intended to be used in chemical reactors for producing, for example, polymers or other synthesis molecules.

### State of the art

In the field of production and synthesis of chemical substances, in particular in the production of polymers, it is known to use catalysts, i.e. chemical species (e.g. molecules, macromolecules, materials in crystalline form or even microorganisms) which take part in a chemical reaction without being consumed by the reaction itself. Such species are used in order to decrease the activation energy necessary for obtaining the chemical reaction between the reagents, which would otherwise occur with very long times, facilitating or mediating the transformation between the reagents themselves.

More in detail, if the catalysts are found in the same phase as the reagents, the catalysis is termed "homogeneous", while if the catalysts are found in a different phase with respect to the reagents the catalysis is termed "heterogeneous".

Generally, where possible, a heterogeneous catalysis is preferable since it is not necessary to remove the catalyst from the product of reaction between the reagents.

In such case, it is known to use metallic catalysts generally containing iron, silver, ruthenium, palladium, platinum, gadolinium or rhodium deposited in thin films by means of cathode pulverization (more commonly termed "sputtering") on support surfaces of catalyst elements inserted in the reactors.

It is also known to use catalysts constituted by insulating metal oxides or semiconductors, on their own or in combination with electromagnetic waves, such as for example titanium dioxide, cerium dioxide, zirconium dioxide, aluminum dioxide, silica, magnesium oxide, zinc oxide or nickel oxide.

The above-described heterogeneous catalysts have in practice demonstrated that they do not lack drawbacks.

A first drawback of the above-described heterogeneous catalysts lies in the fact that, even if they are suitable for catalyzing a rather large number of chemical reactions - in general reactions which involve the hydrogenation and dehydrogenation of chemical compounds, the dehydration, the oxidation, the cracking of the hydrocarbons, the alkylation - their use remains limited to the application of polymerization reactions. For example, chromium oxide based catalysts are mainly known for the polymerization of polyethylene, and titanium tetrachloride based catalysts are known in the Ziegler-Natta processes for polymerization of several other polymers (though in combination with an aluminum organometallic compound).

A further drawback of the known heterogeneous catalysts lies in the fact that they are often costly, in particular if made of precious material (e.g. platinum) or hard to retrieve, extract and work (e.g. the rare-earth elements like cerium).

A further drawback of the known heterogeneous catalysts lies in the fact that they are not often suitable for the synthesis of enantiomerically pure compounds, i.e. constituted by molecules that are structurally identical and ideally superimposable. Indeed such heterogeneous catalysts are unable to selectively catalyze a reaction in a manner such that the reagents are transformed into a single stereoisomer of the reaction product. The reaction product is therefore a mixture of stereoisomers which, in most cases (if possible), must be separated by means of complex and costly processes.

Otherwise, in most cases, the synthesis of the polymers and prepolymers, in particular that of polyurethanes, is assisted by catalysts of homogeneous type.

In particular, the catalysts most used are generally of organometallic type (or metal-organic type), i.e. compounds with formula Me-R that contain a covalent or ionic bond between a carbon atom (of an alkyl group R) and a metal (Me), such as lithium, magnesium and in some cases sodium, copper and zinc or other transition metals.

Other organometallic catalysts have general formula R-Me-X, in which X represents a halogen. In such case, the most well-known catalysts comprise a magnesium atom as halogen and are known as Grignard reagents.

Also the above-described homogeneous catalysts have in practice demonstrated that they do not lack drawbacks.

A first drawback of the homogeneous catalysts lies in the difficulty of separation of the catalyst from the reaction product. Such aspect involves both the risk of contamination of the product by metals, and the impossibility to reuse the entire catalyst, with consequent economic damage.

In particular, the problem of contamination is particularly important in the pharmaceutical industry, where the purities of the compounds must be extremely high. A further drawback of the known homogeneous catalysts lies in the fact that the residue present in the finished product continues to interact with the product itself, continuing undesired secondary reactions. For example, the catalyst residue present in the polyurethane prepolymers used for the production of instantaneous spray foams promotes the process of crosslinking of the prepolymer within the container, deteriorating the product and determining a limited shelf lifetime. Such process, which occurs naturally in a very quick manner when the prepolymer is placed in contact with the humidity of the air, i.e. when it is used, would instead be extremely slow within the container if the catalyst was not present.

A further drawback of the known homogeneous catalysts lies in the fact that they do not allow obtaining continuous synthesis processes and therefore do not allow obtaining lower or higher quantities of product with respect to those dictated by the sizing of the chemical reactor where they are used.

A further drawback of the known homogeneous catalysts finally lies in the difficulty of disposal, due to the presence of metals at their interior that cannot be released into the environment.

In the field, there is therefore the great need to find an alternative to the organometallic catalysts used in the homogeneous catalysis for the synthesis of chemical compounds of various type, which nevertheless does not have the disadvantages of the known heterogeneous catalysts.

In different applications, it is known to use plasma deposition for applying functional coatings. For example, the document DE 102017219311 describes a process of known type for making a hydrophobic coating for an adhesive strip, which provides for the use of a non-metallic organic catalyst employed with HMDSO (hexamethyldisiloxane) base, which originates a layer of silicon oxide (SiOx). The document US 2012009231 describes a further process of known type for making a functional coating by means of the use of a non-metallic organic catalyst with HDFDA (heptadecafluorodecylacrylate) base.

### Presentation of the invention

In this situation, the problem underlying the present invention is therefore that of overcoming the drawbacks manifested by the abovementioned solutions of known type by providing a process for making a catalytic coating and a catalyst device for heterogeneous catalysis, which allow obtaining in a simple manner catalyst devices with high specific surface area capable of being used in chemical reactors operating with heterogeneous catalysis.

A further object of the present invention is to provide a catalyst device for heterogeneous catalysis, which allows substituting industrial processes, today executed in homogeneous catalysis, with processes attainable in heterogeneous catalysis.

A further object of the present invention is to provide a process, which allows obtaining a catalytic coating that is versatile in use.

A further object of the present invention is to provide a process, which allows obtaining a catalytic coating suitable for the heterogeneous catalysis of a reaction.

A further object of the present invention is to provide a catalyst device, which is usable in a continuous process.

A further object of the present invention is to provide a process and a catalyst device, which are simple and inexpensive to attain.

### Brief description of the drawings

The technical characteristics of the present invention, according to the aforesaid objects, can be seen in the contents of the below-reported claims and the advantages of the same will be more evident in the following detailed description, made with reference to the enclosed figures, which represent a merely exemplifying and non-limiting embodiment of the invention in which:
- figure 1 shows a sectional view of an example of a plasma generator device usable for actuating the present process;
- figure 2 shows a perspective of a laminar substrate coated with a catalytic coating obtained with the present process, such substrate is employable for making a catalyst device;
- figure 3 shows a perspective of the substrate of figure 2 wound in spiral shape;
- figure 4 shows a perspective of a catalyst device in cartridge form comprising the substrate of figure 3;
- figure 5 shows a perspective of a substrate in helical impeller form.

### Detailed description of several preferred embodiments

With reference to the enclosed drawings, reference number 1 overall indicates a catalytic coating obtainable with the process, object of the present finding.

The process for making a catalytic coating 1 is advantageously intended for the production of coatings with catalytic functions for the chemical industry, in particular for heterogeneous catalyst devices used within chemical reactors. In addition, the process, object of the invention, is advantageously intended to be employed in the production of catalyst devices 100 with different shapes and sizes and with high specific surface area, for the heterogeneous catalysis of different chemical reactions, in particular polymerization.

More in detail, the catalyst device 100, obtained preferably by means of the process, object of the invention, is advantageously intended to be employed in the chemical and pharmaceutical industry for the synthesis of chemical compounds.

In accordance with the idea underlying the present invention, the process for making a catalytic coating 1 comprises a step of arranging a plasma generation device 2.

Such plasma generation device 2 comprises an ionization duct 3, which is extended between an inlet section 31 and an outlet section 32, and at least one electromagnetic field generator 4 placed at a portion of the ionization duct 3.

In particular, the electromagnetic field generator 4 can be of any type suitable for generating plasma. For example, the electromagnetic field generator 4 can be power supplied with source with direct current (DC), alternating current with radiofrequencies (RF, from 3 kHz to 300 GHz, in particular alternating current with high frequencies, HF) or with pulsed and microwave sources.

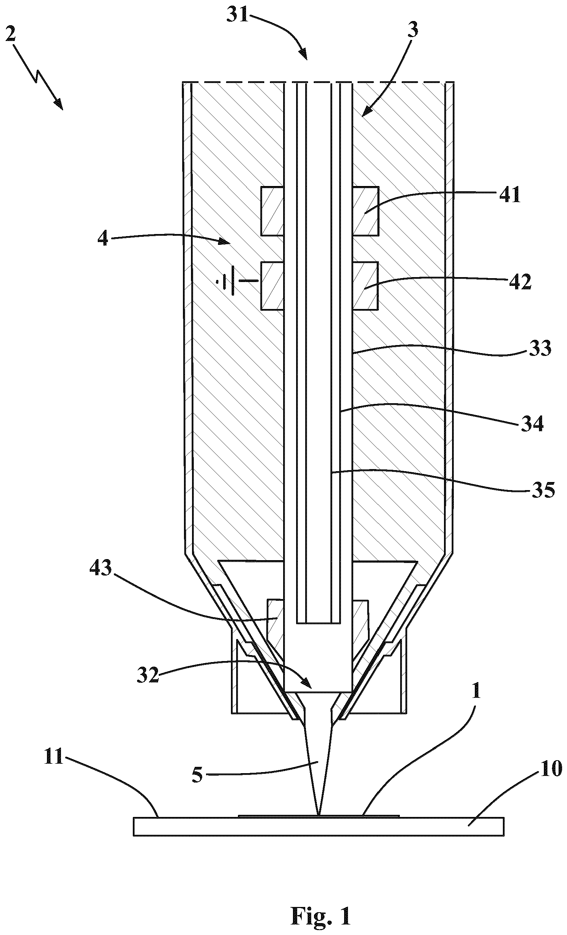

In accordance with an embodiment illustrated in figure 1, the ionization duct 3 of the plasma generation device 4 comprises a first tubular body 33 made of dielectric material.

The electromagnetic field generator 4 advantageously comprises a first annular electrode 41 and a second annular electrode 42 intended to be polarized in High Frequency (HF). In particular, the first and the second annular electrodes 41, 42 are placed one after the other, coaxially, around the first tubular body 33 and one between the first and the second annular electrode 41, 42 is grounded while the other is intended to be connected to the power supply. In addition, the electromagnetic field generator 4 advantageously comprises a third annular electrode 43 intended to be polarized in Radio Frequency (RF), which is placed at the outlet section 32 of the ionization duct 3. Advantageously, the plasma generation device 2 also comprises an evaporation chamber (not illustrated in the enclosed figures), in fluid communication with the inlet section 31 of the ionization duct 3.

According to the invention, the arranging step also provides for arranging a substrate 10, which is placed at the outlet section 32 of the plasma generation device 2 and is provided with a support surface 11 directed towards the aforesaid outlet section 32. Advantageously, the substrate 10 is made of at least one material selected from among metallic, polymer or ceramic materials.

In addition, the arranging step provides for arranging of a precursor of a non-metallic organic catalyst, preferably a volatile precursor.

With the expression "non-metallic organic catalyst" it is intended an organic compound lacking metallic atoms provided with catalytic functions, i.e. intended to take part in a pre-established chemical reaction in order to increase the reaction speed without being consumed by the reaction itself.

With the term "precursor" it is intended any organic molecule, substantially containing the same atoms or groups of atoms of the non-metallic organic catalyst, which is susceptible of being transformed into a compound with catalytic functions. The precursor can already be a molecule with catalytic functions or an inert molecule or a solvent.

According to the invention, the precursor is selected from among a compound of the group comprising: dimethylaminoethanol, bis(dimethylamino)dimethylsilane, N,N,N'-trimethyl-N'-hydroxyethyl-bisaminoethylether, N-(3-dimethylaminopropyl)-N,N-diisopropanolamine (DPA), N,N-bis(3-dimethylaminopropyl)-N-isopropanolamine, N'-(3-(dimethylamino)propyl)-N,N-dimethyl-1,3-propanediamine, 2-(2-dimethylaminoethoxy)ethanol, N,N,N' -trimethylaminoethylethanolamine, dimethylaminopropylamine (DMAPA), allylamine, dimethylacrylamide, N-(2-aminoethyl)-3-aminopropyltrimethoxysilane, methyltriethoxysilane, cyanobutylmethyldimethoxysilane, cyanobutyltriethoxysilane, hexamethyldisilazane, acetonitrile, acrylonitrile, acrylic acid, methacrylic acid, methylmethacrylate, hydroxyethylmethacrylate, ethyloxazoline, ethylenediamine, diethylaminoethylmethacrylate, thiophene, methylthiophene, mercaptopropyltrimethoxysilane, pyrrole and relative mixtures.

Advantageously, in the arranging step, the precursor is placed within the evaporation chamber at least partially in liquid or gaseous phase. For example, the precursor is a volatile precursor, which is gas or vapor form at ambient temperature and pressure.

Otherwise, the precursor can be a liquid or a solid, pure or mixed with a solvent, which is brought to gas or vapor phase within the evaporation chamber by means of diminution of the pressure, for example by applying vacuum, and/or by means of increase of the temperature.

In accordance with a particular embodiment, the arranging step provides for placing, within the evaporation chamber, the precursor in liquid phase and a transport gas, for example one from among air, helium, hydrogen, neon, nitrogen, argon, oxygen or mixtures, which is made to gurgle through the precursor in liquid phase. Advantageously, therefore, the transport gas is mixed with the vapors of the precursor, transporting it therewith.

In accordance with a further embodiment the precursor in liquid phase is nebulized within the transport gas, obtaining a two-phase aerosol.

According to the invention, the process comprises a feeding step, in which the precursor is introduced into the ionization duct 3 through the inlet section 31.

Advantageously, in the feeding step the precursor is transported by the evaporation chamber to the ionization duct 31, for example by means of the transport gas. According to the invention, the process also comprises an ionization step, in which the electromagnetic field generator 4 generates an electromagnetic field which interacts with the precursor in the ionization duct 3 and ionizes the precursor. In this manner, the magnetic field generator 4 produces ionized fragments 5 of the precursor.

With the expression "ionized fragments", it is intended portions of the original molecule of the precursor to which electrons are advantageously admixed or removed and/or which, by means of ionization, are advantageously separated from each other, breaking the covalent bonds between one or more atoms. In particular, the ionized fragments 5 can be single atoms or groups of atoms (comprised the entire precursor).

According to the invention, the process also comprises a coating step, in which the ionized fragments 5 of the precursor exit outward from the outlet section 32 of the ionization duct 3 and are applied to the support surface 11 of the substrate 10, and in which the ionized fragments 5 react with each other forming at least one plasma-polymer with catalytic functions. In particular, the plasma-polymer forms, at least partially, a catalytic coating 1 on the support surface 11.

In particular, at the outlet section 32 of the ionization duct 3, it is possible to find negatively ionized fragments (anions), positively ionized fragments (cations), free electrons, radicals and/or intact precursor.

More in detail, the ionized fragments 5 of precursor advantageously comprise ionized monomer units which are recombined with each other on the substrate 10, forming the plasma-polymer.

In this manner, advantageously a catalytic coating 1 is obtained by means of plasma deposition, in which the catalytic coating 1 contains a plasma-polymer with catalytic functions. Such process is easy to actuate and allows attaining catalyst devices 100 with high specific surface area capable of being used in chemical reactors operating with heterogeneous catalysis, for example in the polymer or pharmaceutical industry.

In addition, it was surprisingly found that with the present process it is possible to use both precursors that are not per se provided with catalytic functions, and precursors which are generally used as catalysts in homogeneous phase. It is also possible to use a mixture of precursors of the two different types.

Advantageously, the precursor comprises at least one atom selected from among: nitrogen, sulfur, oxygen. In particular, such atom in the ionization step and in the coating step is contained in one of the ionized fragments 5. Therefore, such atom is also contained in the plasma-polymer. Advantageously, such atom in the plasma-polymer is provided with at least one free electron pair, i.e. not engaged in a bond with other atoms. Among the abovementioned atoms, it is preferable that the precursor contains at least nitrogen or sulfur and in particular the best results were obtained with precursors containing at least nitrogen.

In accordance with a preferred embodiment of the invention, the precursor and/or the plasma-polymer comprises at least one nitrogenous functional group. In particular, the precursor and/or the plasma-polymer are advantageously selected from among the following groups of organic compounds: amines, heterocyclic amines, amides, imides, imines, nitriles and isonitriles, silazanes, aminosilanes, and relative mixtures. Preferably, the plasma-polymer is a tertiary amine comprising at least one functional group -NR₂, a secondary amine comprising at least one functional group -NHR, or a primary amine comprising at least one functional group -NH₂, in which R is an alkyl group, preferably a methyl group. Such plasma-polymer is advantageously obtainable starting from one of the abovementioned groups of precursors.

For example, the precursor is selected from among a compound of the group comprising: dimethylaminoethanol, bis(dimethylamino)dimethylsilane, N,N,N'-trimethyl-N'-hydroxyethyl-bisaminoethylether, N-(3-dimethylaminopropyl)-N,N-diisopropanolamine (DPA), N,N-bis(3-dimethylaminopropyl)-N-isopropanolamine, N'-(3-(dimethylamino)propyl)-N,N-dimethyl-1,3-propanediamine, 2-(2-dimethylaminoethoxy)ethanol, N,N,N'-trimethylaminoethylethanolamine, dimethylaminopropylamine (DMAPA), allylamine, dimethylacrylamide, N-(2-aminoethyl)-3-aminopropyltrimethoxysilane, cyanobutylmethyldimethoxysilane, cyanobutyltriethoxysilane, hexamethyldisilazane, acetonitrile, acrylonitrile, ethyloxazoline, ethylenediamine, diethylaminoethylmethacrylate, pyrrole, their isomers or stereoisomers, and relative mixtures.

In accordance with a further embodiment of the invention, the precursor and/or the plasma-polymer comprises at least one functional group containing sulfur. In particular, the precursor and/or the plasma-polymer are advantageously selected from among the following groups of organic compounds: thiols, mercaptans, sulfides, disulfides, sulfones, sulfoxides, sulfonic acids, sulfinic acids, thiophenes, and relative mixtures. For example, the precursor is selected from among a compound of the group comprising: methylthiophene, thiophene, mercaptopropyltrimethoxysilane, their isomers or stereoisomers, and relative mixtures.

In accordance with a further embodiment of the invention, the precursor and/or the plasma-polymer comprises at least one functional group containing oxygen. In particular, the precursor and/or the plasma-polymer are advantageously selected from among the following groups of organic compounds: siloxanes, polyols, ethers, alcoxysilanes, acrylates, methacrylates, and relative mixtures.

For example, the precursor is selected from among a compound of the group comprising: N,N,N'-trimethyl-N'-hydroxyethyl-bisaminoethylether, N-(3-dimethylaminopropyl)-N,N-diisopropanolamine (DPA), N,N-bis(3-dimethylaminopropyl)-N-isopropanolamine, 2-(2-dimethylaminoethoxy)ethanol, N,N,N'-trimethylaminoethylethanolamine, dimethylacrylamide, N-(2-aminoethyl)-3-aminopropyltrimethoxysilane, methyltriethoxysilane, cyanobutylmethyldimethoxysilane, cyanobutyltriethoxysilane, acrylic acid, methacrylic acid, methylmethacrylate, hydroxyethylmethacrylate, ethyloxazoline, diethylaminoethylmethacrylate, mercaptopropyltrimethoxysilane, their isomers or stereoisomers, and relative mixtures.

In order to improve the adhesion of the catalytic coating 1 to the support surface 11 of the substrate 10, in particular if the latter is made of metal, the plasma-polymer comprises at least one siloxane group. In particular, the aforesaid siloxane group in the coating step is chemically bonded to the support surface 11 of the substrate 10.

More in detail, the siloxane group is advantageously present in the precursor. In addition, in the ionization step and in the coating step such siloxane group is advantageously contained in at least one of the ionized fragments 5.

In accordance with a preferred embodiment of the invention, the precursor is selected from among the following groups of compounds: amines, siloxanes, silazanes, aminosilanes, thiophenes or mixtures thereof.

Advantageously, the catalytic coating 1 is provided with catalytic functions for a chemical reaction selected from among: synthesis reactions of urethane prepolymers and/or polymers, synthesis reactions of isocyanurate prepolymers and/or polymers, polycondensation reactions, polymerization reactions catalyzed by Bronsted bases, synthesis reactions of thermosetting resins.

Advantageously, the process also provides for a triggering step, in which an activation gas, preferably argon, is introduced into the ionization duct 3 at least at the electromagnetic field generator 4, for example at one of the annular electrodes 41, 42, 43, and the electromagnetic field interacts with the activation gas, ionizing it. In this manner, the electromagnetic field carries the activation gas in plasma state. Advantageously, in addition, in the ionization step, the precursor is introduced into the activation gas in plasma state in order to generate the ionized fragments 5 of the precursor.

In particular, the triggering step is advantageously executed before the ionization step. In accordance with the embodiment illustrated in figure 1, the ionization duct 3 of the plasma generation device 2 comprises at least one second tubular body 34 and preferably also a third tubular body 35 placed within such second tubular body 34, and preferably both placed inside the first tubular body 33.

Advantageously, the precursor is transported in gaseous phase or as aerosol within the second tubular body 34, and the activation gas is transported into the annular volume comprised between the first tubular body 33 and the second tubular body 34.

In accordance with an embodiment variant, the precursor is transported in liquid phase within the third tubular body 35 and the transport gas into the annular volume comprised between the second tubular body 34 and the third tubular body 35 and the second and third tubular duct 34, 35 terminate at the electromagnetic field generator 4, in particular advantageously at one of the annular electrodes 41, 42, 43 of the electromagnetic field generator 4. Advantageously, therefore, in the feeding step the precursor can be transported in liquid form within the transport duct 3 and nebulized when it encounters the transport gas at the end of the third tubular body 35 at the electromagnetic field generator 4.

Subsequently, at the outlet of the second tubular body 34, the nebulized precursor advantageously encounters the activation gas in plasma phase and is ionized. According to such embodiment variant of the invention, the precursor encounters the activation gas in plasma state at the outlet of the first tubular body 34 shortly before the outlet section 32. At that point, advantageously, the precursor reacts with the activation gas in plasma state, so that it is fragmented and ionized, and then it is reorganized and polymerized on the support surface 11.

According to a possible operative situation, the precursor is not in plasma state and the ionized fragments 5 are produced by the ionized activation gas and are transported thereby towards the support surface 11, where they react and recombine with each other.

According to a further operative situation, the magnetic field generator 4 carries the precursor in plasma state (with or without the triggering of the activation gas) containing the ionized fragments 5 of the precursor.

Of course, without departing from the protective scope of the invention, at least one from among the first, the second and the third tubular bodies 33, 34, 35 of the ionization duct 3 can be separated from the others and can intercept them at the electromagnetic field generator 4. In addition, the ionization duct 3 can be of any size and shape, e.g. with circular, rectangular or square section.

Advantageously, the process comprises a movement step, during the coating step, in which the plasma generation device 2 and/or the substrate 10 are moved relative to each other along a direction parallel to the support surface 11 of the substrate 10 in order to treat in succession non-coated areas of the support surface 11 itself.

In accordance with an embodiment variant of the process, the step of arranging the substrate 10 provides for making the aforesaid substrate 10 by means of a 3D printer, for example of FDM (Fused Deposition Modelling) type, provided with at least one dispensing nozzle.

Advantageously, in the arranging step, the dispensing nozzle of the 3D printer is actuated to be moved along a generation path in order to dispense a base material along the generation path in order to form the substrate 10.

In particular, the step of arranging the substrate provides for using a 3D printer, of per se known type, provided with a dispensing nozzle heated to a specific pre-established temperature, on which a passage hole is made, and with a wire of base material passing through the passage hole. Advantageously, the base material is susceptible of melting at the aforesaid temperature of the dispensing nozzle, and preferably it is a thermoplastic polymer, e.g. ABS.

Advantageously, in the coating step, the plasma generation device 2 is moved simultaneously with the dispensing nozzle of the 3D printer, in a manner such that the outlet section 32 of the ionization duct 3 follows the dispensing nozzle in order to deposit the catalytic coating 1 on at least one part of the base material dispensed by the dispensing nozzle along the generation path, in particular on the base material which constitutes the support surface 11 of the substrate 10.

More in detail, the step of arranging the substrate 10, in particular by means of 3D printing, occurs simultaneously with the movement step and with the coating step. In particular, during the movement step the plasma generation device 2 is moved to a pre-established distance from the movement nozzle of the 3D printer with a time delay. In this manner, the catalytic coating 1 is attained on the support surface 11 during the making of the latter.

Advantageously, each of the aforesaid steps of the process can be attained at atmospheric pressure or in vacuum conditions.

In addition, the steps of the process are preferably attained continuously until complete coating of the support surface 11 of the substrate 10.

Also forming the object of the present invention is a catalyst device 100 for heterogeneous catalysis, advantageously obtained by means of the above-described process, regarding which the reference numbers will be maintained for the sake of description simplicity.

According to the invention the catalyst device 100 for heterogeneous catalysis comprises a substrate 10 provided with a support surface 11 and with a catalytic coating 1, fixed to the support surface 11.

Advantageously, the substrate 10 is made of at least one material selected from among metallic, polymer or ceramic materials.

In accordance with the idea underlying the present invention, the catalytic coating 1 comprises at least one non-metallic organic catalyst in plasma-polymer form chemically bonded to the support surface 11.

Advantageously, the catalytic coating 1 is obtained by means of plasma deposition starting from a precursor of the organic catalyst, preferably by means of the process described above. In particular, the plasma deposition can be a plasma vapor deposition at atmospheric pressure (APVD, atmospheric plasma vapor deposition), a plasma liquid deposition at atmospheric pressure (APLD, atmospheric plasma liquid deposition) or a plasma deposition under vacuum (PECVD, plasma enhanced chemical vapor deposition).

In accordance with a preferred embodiment of the invention, the plasma-polymer advantageously comprises at least one atom selected from among: nitrogen, sulfur, oxygen. Advantageously, such atom in the plasma-polymer is provided with at least one free electron pair, i.e. not engaged in a bond with other atoms.

Preferably, the plasma-polymer of the catalytic coating 1 is an amine. Preferably, in addition, the plasma-polymer comprises at least one nitrogenous group with generic formula -NR₂ (tertiary amine), -NHR (secondary amine) or -NH₂ (primary amine), in which R is an alkyl group, preferably methyl.

In order to improve the adhesion of the catalytic coating 1 to the support surface 11 of the substrate 10, in particular if the latter is made of metal, the plasma-polymer comprises at least one siloxane group. In particular, the aforesaid siloxane group in the coating step is chemically bonded to the support surface 11 of the substrate 10.

Advantageously, therefore, the plasma-polymer is an aminosiloxane.

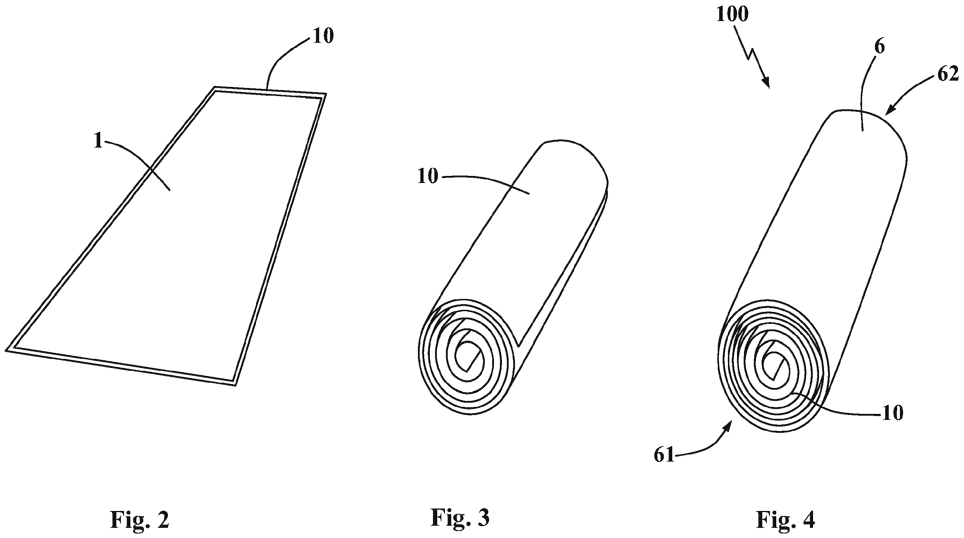

The catalyst device 100 can be made of various shapes and sizes, as a function of the specific application destinations. For example, the catalyst device 100 can be made of tubular cartridge form for a reactor with continuous heterogeneous catalysis, as illustrated in figure 4. In such case, the substrate 10 is advantageously provided with a body with spiral shape, provided with the support surface 11 on which the catalytic coating 1 is placed. Alternatively, the substrate 10 can also be provided with a body with helical shape.

In addition, the catalyst device 100 advantageously comprises a containment chamber 6 of tubular shape, which is extended between an inlet mouth 61 in order to make a flow of at least one reagent enter, and an outlet mouth 62 in order to make a reaction product exit. Within the containment chamber 6, the substrate 10 in spiral shape with the catalytic coating 1 is advantageously intended to be inserted, in order to catalyze a chemical reaction adapted to transform the reagent (or the reagents) into the reaction product.

For example, the catalytic coating 1 is provided with catalytic functions for a chemical reaction selected from among: synthesis reactions of urethane prepolymers and/or polymers, synthesis reactions of isocyanurate prepolymers and/or polymers, polycondensation reactions, polymerization reactions catalyzed by Bronsted bases, synthesis reactions of thermosetting resins.

Of course, without departing from the protective scope of the invention, the catalyst device 100 can be made of other forms. For example, in a non-illustrated embodiment, the catalyst device 100 is made in impeller form for a chemical reactor, i.e. by coating the impeller with the catalytic coating 1, in a manner such that the reaction between the reagents is catalyzed when they come into contact with the impeller.

A first embodiment of a catalyst device 100 according to the invention is described hereinbelow.

In accordance with the first embodiment, a substrate 10 of laminar form made of AISI 301 steel was subjected to a plasma deposition treatment at atmospheric pressure in accordance with the above-described process. The substrate 10 with laminar form was treated on both support surfaces 11 with a power of the plasma generator device 4 of 40 W at a treatment speed of 8 cm²/min.

As precursor, dimethylaminoethanol was used in vapor phase at atmospheric pressure. The plasma was activated by means of argon.

A substrate 10 with a catalytic coating 1 was therefore obtained, schematically illustrated in figure 2. It was observed that the catalytic coating 1 thus obtained is provided with functional groups -N(CH₃)₂, which act as catalytic site.

Subsequently, the substrate 11 with catalytic coating 1 was shaped in spiral shape and inserted in a tubular containment chamber 6, as illustrated in figures 3 and 4.

A second embodiment of a catalyst device 100 according to the invention is described hereinbelow.

In accordance with the second embodiment, a substrate 10 with laminar shape made of AISI 301 steel was subjected to a plasma deposition treatment at atmospheric pressure in accordance with the above-described process. The substrate 10 of laminar form was treated on both support surfaces 11 with a power of the plasma generator device 4 of 30 W at a treatment speed of 8 cm²/min.

As precursor, bis(dimethylamino)dimethylsilane was used in vapor phase at atmospheric pressure. The plasma was activated by means of argon.

A substrate 10 with a catalytic coating 1 was then obtained. Also in this case, it was observed that the catalytic coating 1 thus obtained is provided with functional groups -N(CH₃)₂, which act as catalytic site. In addition, an improved adhesion of the catalytic coating 1 on the metallic support surface 11 was observed, due to the presence of siloxane groups in the plasma-polymer.

Subsequently, the substrate 10 with catalytic coating 1 was shaped in spiral shape and inserted in a tubular containment chamber 6, as indicated in the first embodiment.

A third embodiment of a catalyst device 100 according to the invention is described hereinbelow.

In accordance with the third embodiment, a substrate 10 of laminar form made of AISI 301 steel was subjected to a plasma deposition treatment at atmospheric pressure in accordance with the above-described process. The substrate 10 with laminar form was treated on both support surfaces 11 with a power of the plasma generator device 5 of 50 W at a treatment speed of 1 m²/h. As precursor, 3-methylthiophene in vapor phase at atmospheric pressure was used. The plasma was activated by means of argon. A substrate 10 with a catalytic coating 1 was therefore obtained.

In this case, it was observed that the catalytic coating 1 thus obtained is provided with functional groups containing sulfur (-SR₂, -SRH) which act as catalytic site. Subsequently, the substrate 10 with catalytic coating 1 was shaped in spiral shape and inserted in a tubular containment chamber 6, as indicated in the first embodiment.

A fourth embodiment of a catalyst device 100 according to the invention is described hereinbelow.

The fourth embodiment provides for the use of a substrate 10 of laminar form made of anodized titanium. Such support was subjected to an assisted plasma deposition treatment, employing hexamethyldisilazane vapors as precursor. A substrate 10 with a catalytic coating 1 was therefore obtained. It was observed that the catalytic coating 1 thus obtained is provided with functional groups containing nitrogen (-NH₂, -NHR, - NR₂), which act as catalytic site.

In addition, a greater adhesion of the catalytic coating 1 on the metallic support surface 11 was observed, due to the presence of siloxane groups in the plasma-polymer. Subsequently, the substrate 10 with catalytic coating 1 was shaped in spiral shape and inserted in a tubular containment chamber 6, as indicated in the first embodiment.

A fifth embodiment of a catalyst device 100 according to the invention is described hereinbelow.

The fifth embodiment provides for employing the plasma generation device 2 described above and illustrated in figure 1 as additional module for 3D printers of FDM type.

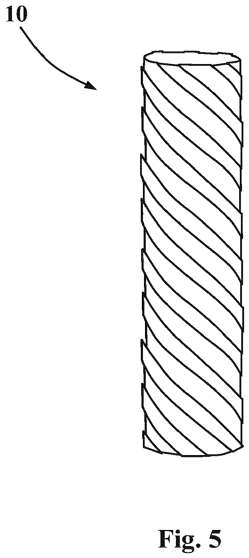

In particular, a substrate 10 of helical impeller form was attained by means of 3D printing, illustrated in figure 5, and made of polymer material, in particular ABS. During the attainment of such impeller, which occurs by means of ABS printing layer after layer, the plasma generation device 2 intervened, after the printing of each single layer of ABS, in order to functionalize the just-printed surface.

For such deposition treatment in accordance with the process, dimethylaminoethanol was employed as precursor, and a substrate 10 with a catalytic coating 1 was therefore attained. It was observed that the catalytic coating 1 thus obtained is provided with functional groups containing nitrogen (-NH₂, -NHR, -NR₂), which act as catalytic site. The substrate 10 was made of dimensions suitable such that it can be inserted in a tubular containment chamber 6, as in the first embodiment.

A sixth embodiment of a catalyst device 100 according to the invention is described hereinbelow.

The sixth embodiment provides for employing the plasma generation device 2, as additional module for 3D printers of FDM type, as described in the fifth embodiment.

In particular, by means of 3D printing a substrate 10 was attained in helical impeller form, illustrated in figure 5, and of polymer material, in particular PLA (polylactic acid). During the attainment of such impeller, which occurs by means of PLA printing layer after layer, the plasma generation device 2 intervened, after the printing of each single layer of PLA, in order to functionalize the just-printed surface.

For such deposition treatment in accordance with the process, hexamethyldisilazane was employed as precursor, and a substrate 10 was then obtained with a catalytic coating 1. It was observed that the catalytic coating 1 thus obtained is provided with functional groups containing nitrogen (-NH₂, -NHR, -NR₂), which act as catalytic site. The substrate 10 was attained with dimensions suitable for it to be inserted in a tubular containment chamber 6, as in the first embodiment.

Each catalyst device 100 obtained according to each described embodiment was tested to order to catalyze a synthesis reaction of a urethane prepolymer of the type that can be introduced within spray bombs in order to obtain expanded polyurethane. It was observed that, in all the aforesaid first, second, third, fourth and fifth embodiments, the catalyst device 100 is provided with good catalytic functions without the catalyst remaining within the prepolymer. In addition, the lifetime of the prepolymer thus obtained before being used results longer, in the absence of homogeneous catalysts not removed after the synthesis reaction of the prepolymer.

The invention thus conceived therefore attains the pre-established objects.

## Claims

1. Process for making a catalytic coating (1), **characterized in that** it comprises the following steps:
- a step of arranging:
- a plasma generation device (2), comprising:
- an ionization duct (3), which is extended between an inlet section (31) and an outlet section (32),
- and at least one electromagnetic field generator (4) placed at a portion of the ionization duct (3);
- a substrate (10), which is placed at the outlet section (32) of the plasma generation device (2) and is provided with a support surface (11) directed towards said outlet section (32);
- a precursor of a non-metallic organic catalyst, wherein said precursor is selected from among a compound of the group comprising dimethylaminoethanol, bis(dimethylamino)dimethylsilane, N,N,N'-trimethyl-N'-hydroxyethyl-bisaminoethylether, N-(3-dimethylaminopropyl)-N,N-diisopropanolamine (DPA), N,N-bis(3-dimethylaminopropyl)-N-isopropanolamine, N'-(3-(dimethylamino)propyl)-N,N-dimethyl-1,3-propanediamine, 2-(2-dimethylaminoethoxy)ethanol, N,N,N'-trimethylaminoethylethanolamine, dimethylaminopropylamine (DMAPA) allylamine, dimethylacrylamide, N-(2-aminoethyl)-3-aminopropyltrimethoxysilane, methyltriethoxysilane, cyanobutylmethyldimethoxysilane, cyanobutyltriethoxysilane, hexamethyldisilazane, acetonitrile, acrylonitrile, acrylic acid, methacrylic acid, methylmethacrylate, hydroxyethylmethacrylate, ethyloxazoline, ethylenediamine, diethylaminoethylmethacrylate, thiophene, methylthiophene, mercaptopropyltrimethoxysilane, pyrrole and relative mixtures;
- a feeding step, wherein said precursor is introduced into said ionization duct (3) through said inlet section (31);
- an ionization step, wherein said electromagnetic field generator (4) generates an electromagnetic field which interacts with said precursor in said ionization duct and ionizes said precursor, producing ionized fragments (5) of said precursor;
- a coating step, wherein the ionized fragments (5) of said precursor exit outward from the outlet section (32) of said ionization duct (3) and are applied to the support surface (11) of said substrate (10), and wherein said ionized fragments (5) react with each other, forming at least one plasma-polymer with catalytic functions, and said plasma-polymer forms, at least partially, a catalytic coating (1) on said support surface (11).

2. Process according to claim 1, **characterized in that** said precursor comprises at least one atom selected from among: nitrogen, sulfur, oxygen, preferably nitrogen, wherein said atom in said ionization step and in said coating step is contained in a said ionized fragment.

3. Process according to claim 2, **characterized in that** said precursor and/or said plasma-polymer comprises at least one nitric functional group, said precursor and/or said plasma-polymer being selected from among the following groups of organic compounds: amines, heterocyclic amines, amides, imides, imines, nitriles and isonitriles, silazanes, aminosilanes, and relative mixtures.

4. Process according to claim 3, **characterized in that** said plasma-polymer is a tertiary amine comprising at least one -NR₂ functional group, a secondary amine comprising at least one -NHR functional group, or a primary amine comprising at least one -NH₂ functional group, wherein R is an alkyl group, preferably a methyl group.

5. Process according to any one of the preceding claims, **characterized in that** said plasma-polymer comprises at least one siloxane group, wherein said siloxane group in said coating step is chemically bonded to the support surface (11) of said substrate (10).

6. Process according to any one of the preceding claims, **characterized in that** said catalytic coating (1) is provided with catalytic functions for a chemical reaction selected from among: synthesis reactions of urethane prepolymers and/or polymers, synthesis reactions of isocyanurate prepolymers and/or polymers, polycondensation reactions, polymerization reactions catalyzed by Bronsted bases, synthesis reactions of thermosetting resins.

7. Process according to any one of the preceding claims, **characterized in that** said substrate (10) is made of at least one material selected from among metallic, polymer or ceramic materials.

8. Process according to any one of the preceding claims, **characterized in that** it provides for a triggering step, wherein an activation gas is introduced into said ionization duct (3) at least at said electromagnetic field generator (4), and said electromagnetic field interacts with said activation gas and ionizes said activation gas, bringing said activation gas into plasma state,
wherein, in said ionization step, said precursor is introduced into said activation gas in plasma state in order to generate the ionized fragments (5) of said precursor.

9. Process according to any one of the preceding claims, **characterized in that** said step of arranging said substrate (10) provides for making said substrate (10) by means of a 3D printer provided with at least one dispensing nozzle;
wherein, in said arranging step, the dispensing nozzle of said 3D printer is actuated to be moved along a generation path in order to dispense a base material along said generation path, in order to form said substrate (10),
and wherein, in said coating step, said plasma generation device (2) is moved simultaneously with the dispensing nozzle of said 3D printer, in a manner such that the outlet section (32) of said ionization duct (3) follows said dispensing nozzle in order to deposit said catalytic coating on at least one part of said base material dispensed by said dispensing nozzle along said generation path.

10. Catalyst device (100) for heterogeneous catalysis, which comprises a substrate (10) provided with a support surface (11) and with a catalytic coating (1), fixed to said support surface (11),
**characterized in that** said catalytic coating (1) comprises at least one non-metallic organic catalyst in plasma-polymer form chemically bonded to said support surface (11).

11. Catalyst device (100) according to claim 10, **characterized in that** said substrate (10) is provided with a body with spiral or helical shape, provided with said support surface (11) on which said catalytic coating (1) is placed.

12. Catalyst device (100) according to claim 10 or 11, **characterized in that** said plasma-polymer comprises at least one nitrogenous functional group, said plasma-polymer being selected from among the following groups of organic compounds: amines, heterocyclic amines, amides, imides, imines, nitriles and isonitriles, silazanes, aminosilanes, and relative mixtures.

13. Catalyst device (100) according to claim 12, **characterized in that** said plasma-polymer is a tertiary amine comprising at least one functional group -NR₂, a secondary amine comprising at least one functional group -NHR, or a primary amine comprising at least one functional group -NH₂, wherein R is an alkyl group, preferably a methyl group.
